# EUROPEAN PATENT SPECIFICATION

(11) **EP 3 030 065 B1**
(45) Date of publication and mention of the grant of the patent: **14.03.2018**
(21) Application number: 14196223.3
(22) Date of filing: 04.12.2014
(51) Int. Cl.: H05K 7/14

(54) **Cable management arm supporting device and mounting assembly thereof**
Armstützvorrichtung zur Kabelverwaltung und Montageanordnung dafür
Dispositif de support de bras de gestion de câble et ensemble de montage de celui-ci

(43) Date of publication of application: 08.06.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- EP-A1- 2 744 314
- US-A1- 2014 183 306
- US-A1- 2014 328 618
- US-B1- 7 746 667

## Description

### Field of the Invention

The present invention relates to a cable management arm (CMA) and, more particularly, to a cable management arm supporting device whose supporting members can be rapidly assembled to applicable slide rail assemblies and be easily and rapidly detached from the slide rail assemblies when desired.

### Background of the Invention

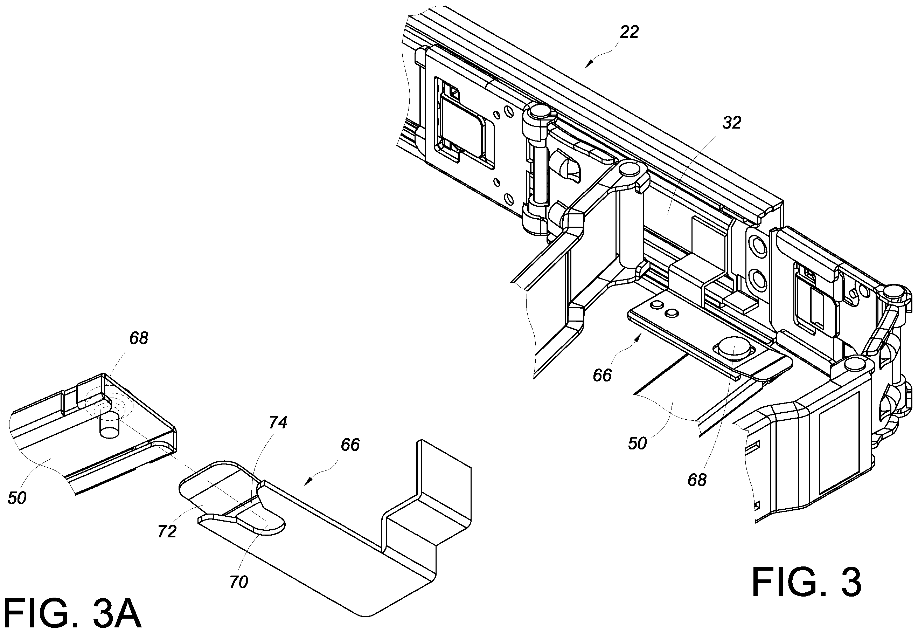

US Patent No. 7,746,667 B1 discloses a telescoping support crossbar for a cable management arm. According to the specification and drawings of this patent, a cable management arm (CMA) (24) includes two pivotally connected support sections (26, 28) which are respectively connected to a chassis member (22) and to a cabinet member (18) of a drawer slide. A telescoping support crossbar (42), on the other hand, includes a first member (46) and a second member (48) slidably extensible from the first member (46). FIGS. 3-5 of the patent also show that the telescoping support crossbar (42) has two ends (50, 52) which are respectively mounted to an end of an intermediate member (20) of a drawer slide and to the cabinet member (18) of another drawer slide via a pivot fastener (60).

While the patent cited above discloses the technical feature of mounting the telescoping support crossbar (42) to drawer slides, it is highly desirable to develop a different cable management arm supporting device which realizes the concept of product simplification and takes into account the ease of mounting so as to meet the changeable needs of related industries.

US2014183306 describes a cable mounting arm supporting device having a mounting assembly with a mounting member which can be rotated into two opposite positions. The mounting member is held in place in each of the two positions by a projection which is engaged in a positioning hole.

### Summary of the Invention

The present invention relates to a cable management arm supporting device whose supporting members can be rapidly assembled to and easily and rapidly detached from applicable slide rail assemblies.

According to one aspect of the present invention, a cable management arm supporting device is provided to be mounted to a first slide rail assembly and a second slide rail assembly. The first slide rail assembly includes a first rail, a second rail, and a third rail movably connected between the first rail and the second rail. The cable management arm supporting device includes a first arm, a first mounting member, a second arm, a second mounting member, a plurality of cable supporting features, a supporting base, a first supporting member, a second supporting member, and a third mounting member. The first arm has a first end and a second end. The first mounting member is connected to the first arm at a position adjacent to the first end of the first arm. In addition, the first mounting member is mounted to the first rail of the first slide rail assembly. The second arm is movably connected to the first arm at a position adjacent to the second end of the first arm. The second mounting member is connected with the second arm and is mounted to the second rail of the first slide rail assembly. The cable supporting features are connected with at least one of the first arm and the second arm. The supporting base has a first supporting portion and a second supporting portion generally perpendicularly connected with the first supporting portion. The first supporting member is movably connected with the first supporting portion of the supporting base. The second supporting member is telescopically connected with the first supporting member and is mounted to the third rail of the first slide rail assembly. The third mounting member is pivotally connected with the second supporting portion of the supporting base and is releasably connected with the second slide rail assembly.

Preferably, the first slide rail assembly further includes a first connector connected with the first rail, and the first mounting member is releasably mounted to the first connector.

Preferably, the first slide rail assembly further includes a second connector connected with the second rail, and the second mounting member is releasably mounted to the second connector.

Preferably, the second slide rail assembly further includes a connector, and the third mounting member further includes a mounting wall and an operation arm connected with the mounting wall. The mounting wall includes at least one fixing portion and a first opening. The operation arm includes a connecting portion connected with the at least one fixing portion and further includes a first elastic portion. The first elastic portion is connected with one side of the connecting portion, corresponds to the first opening, and includes at least one engaging portion for blocking the connector.

Preferably, the mounting wall of the third mounting member further includes a second opening, the operation arm further includes a second elastic portion connected with another side of the connecting portion and corresponding to the second opening and also includes an engaging section connected with the second elastic portion, and the second supporting portion of the supporting base further includes a first positioning portion and a second positioning portion. The engaging section can be selectively engaged with either of the first positioning portion and the second positioning portion.

Preferably, the cable management arm supporting device further includes an elastic element connected between the third mounting member and the second supporting portion of the supporting base, and the second supporting portion of the supporting base further includes a first stop portion and a second stop portion. When pivoted to a first direction, the third mounting member is pressed against the first stop portion due to the elastic element; when pivoted to a second direction opposite the first direction, the third mounting member is pressed against the second stop portion due to the elastic element.

Preferably, the first slide rail assembly further includes an auxiliary element connected with the third rail of the first slide rail assembly and a positioning element connected with the second supporting member. The auxiliary element includes a mounting opening and an elastic arm. The elastic arm has a blocking edge for forming a blockage at the mounting opening. The positioning element is mounted in the mounting opening and can be blocked by the blocking edge of the elastic arm.

Preferably, the cable management arm supporting device further includes a hinge member, and the first arm and the second arm are pivotally connected by the hinge member.

Preferably, the first mounting member is pivotally connected with the first end of the first arm.

Preferably, the second mounting member is pivotally connected with the second arm.

Preferably, the first supporting member is pivotally connected with the first supporting portion of the supporting base.

According to another aspect of the present invention, a mounting assembly applicable to a supporting member includes a supporting base and a mounting member. The supporting base has a first supporting portion and a second supporting portion generally perpendicularly connected with the first supporting portion. The supporting member is movably connected with the first supporting portion. The mounting member is pivotally connected with the second supporting portion of the supporting base.

Preferably, the mounting member further includes a mounting wall and an operation arm connected with the mounting wall. The mounting wall includes at least one fixing portion and a first opening. The operation arm includes a connecting portion connected with the at least one fixing portion and further includes a first elastic portion. The first elastic portion is connected with one side of the connecting portion, corresponds to the first opening, and includes at least one engaging portion for blocking an object.

Preferably, the mounting wall of the mounting member further includes a second opening, the operation arm further includes a second elastic portion connected with another side of the connecting portion and corresponding to the second opening and also includes an engaging section connected with the second elastic portion, and the second supporting portion of the supporting base further includes a first positioning portion and a second positioning portion. The engaging section can be selectively engaged with either of the first positioning portion and the second positioning portion.

Preferably, the mounting assembly further includes an elastic element connected between the mounting member and the second supporting portion of the supporting base, and the second supporting portion of the supporting base further includes a first stop portion and a second stop portion. The mounting member is pressed against the first stop portion due to the elastic element when pivoted to a first direction and is pressed against the second stop portion due to the elastic element when pivoted to a second direction opposite the first direction.

One advantageous feature of implementing the present invention is that the supporting members can be rapidly assembled to applicable slide rail assemblies and be easily and rapidly detached from the slide rail assemblies when desired.

### Brief Description of the Drawings

The invention as well as a preferred mode of use and the advantages thereof will be best understood by referring to the following detailed description of some illustrative embodiments in conjunction with the accompanying drawings, in which:
FIG. 1 is a schematic perspective view in which the cable management arm supporting device according to an embodiment of the present invention is mounted to a first slide rail assembly and a second slide rail assembly;
FIG. 2 is a schematic exploded view in which the cable management arm supporting device of FIG. 1 is separated from the first slide rail assembly and the second slide rail assembly;
FIG. 3 is a schematic perspective view in which the first mounting member, the second mounting member, and the second supporting member of the cable management arm supporting device in an embodiment of the present invention are mounted to the first rail, the second rail, and the third rail of the first slide rail assembly respectively;
FIG. 3A is an exploded view of the second supporting member and an auxiliary element of the third rail of the first slide rail assembly in FIG. 3;
FIG. 4A is a schematic drawing showing how the second supporting member of the cable management arm supporting device in an embodiment of the present invention is mounted to the auxiliary element via a positioning element, which has entered the mounting opening of the auxiliary element and is blocked by the blocking edge;
FIG. 4B is another schematic drawing showing how the second supporting member of the cable management arm supporting device in an embodiment of the present invention is mounted to the auxiliary element via the positioning element, in which the free end of the elastic arm of the auxiliary element has been lifted such that the blocking edge no longer forms a blockage at the mounting opening of the auxiliary element;
FIG. 4C is yet another schematic drawing showing how the second supporting member of the cable management arm supporting device in an embodiment of the present invention is mounted to the auxiliary element via the positioning element, in which the free end of the elastic arm of the auxiliary element has been lifted, allowing the positioning element to be removed from the mounting opening of the auxiliary element;
FIG. 5 is a schematic perspective view showing how the third mounting member of the cable management arm supporting device in an embodiment of the present invention is pivotally connected with the second supporting portion of the supporting base and mounted to a connector of the second slide rail assembly;
FIG. 6 is a schematic exploded view of the third mounting member, the supporting base, and the first supporting member of the cable management arm supporting device in an embodiment of the present invention;
FIG. 7 schematically shows how the third mounting member of the cable management arm supporting device in an embodiment of the present invention can be operated to point to a first direction or a second direction;
FIG. 8A schematically shows how the engaging section of the third mounting member of the cable management arm supporting device in an embodiment of the present invention is engaged with the first positioning portion of the supporting base;
FIG. 8B schematically shows how the third mounting member of the cable management arm supporting device in an embodiment of the present invention is operated to disengage the engaging section from the first positioning portion;
FIG. 9 is a schematic drawing in which the second arm of the cable management arm supporting device in an embodiment of the present invention is close to the first arm and the second supporting member is retracted with respect to the first supporting member;
FIG. 10 is a schematic drawing in which the second mounting member of the cable management arm supporting device in an embodiment of the present invention has been displaced a certain distance from the first mounting member, causing the second arm to extend relative to the first arm, and the second supporting member to displace relative to the first supporting member;
FIG. 11 is a schematic drawing in which the second mounting member of the cable management arm supporting device in an embodiment of the present invention has been displaced further from the first mounting member, causing the second arm to extend further relative to the first arm, and the second supporting member to displace further relative to the first supporting member;
FIG. 12 is a schematic drawing in which the third mounting member of the cable management arm supporting device in another embodiment of the present invention is mounted to the first connector of the first slide rail assembly;
FIG. 13 is a perspective view showing in particular the elastic element connected between the third mounting member and the second supporting portion of the supporting base of the cable management arm supporting device in the second embodiment of the present invention; and
FIG. 14 schematically shows how the third mounting member of the cable management arm supporting device in the second embodiment of the present invention can be limited in position by the stop portions of the second supporting portion of the supporting base when pivoting.

### Detailed Description of the Invention

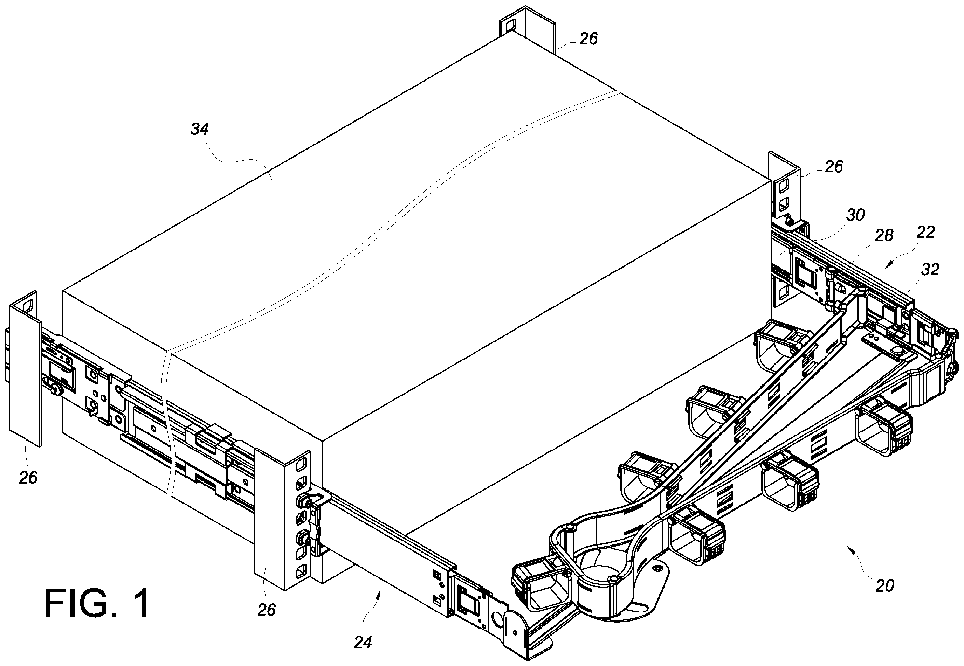

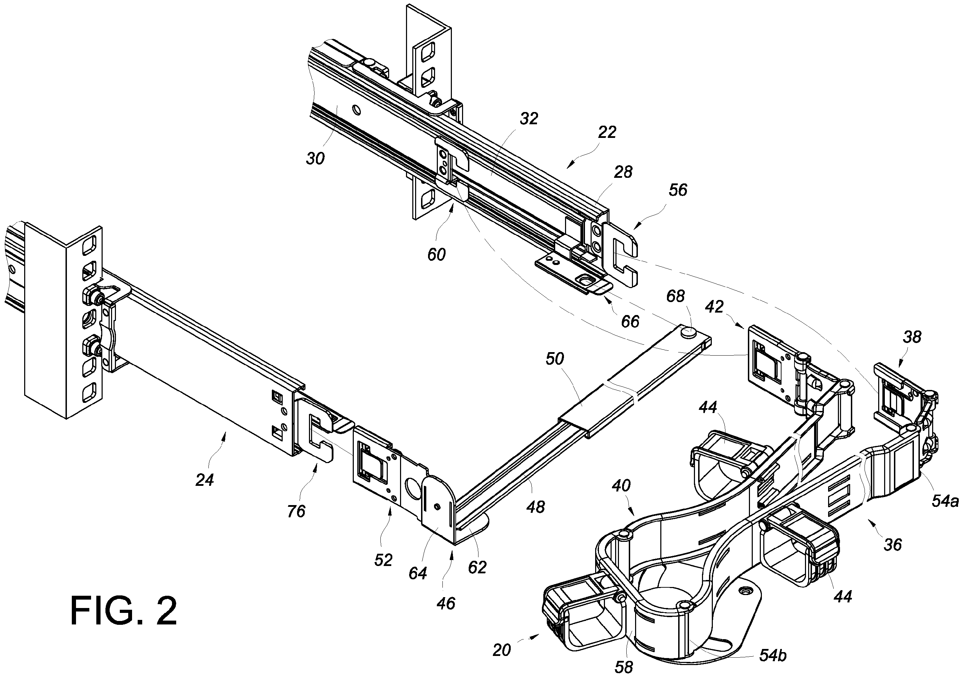

Referring to FIG. 1 and FIG. 2, the cable management arm supporting device 20 in an embodiment of the present invention is mounted to a first slide rail assembly 22 and a second slide rail assembly 24. Each of the slide rail assemblies 22 and 24 is mounted to a corresponding pair of posts 26.

Each of the slide rail assemblies 22 and 24 includes a first rail 28, a second rail 30, and a third rail 32 movably connected between the first rail 28 and the second rail 30 so as to increase the distance by which the second rail 30 can be longitudinally displaced relative to the first rail 28. The chassis 34 of a server can have its two opposite lateral sides mounted to the second rail 30 of the first slide rail assembly 22 and the second rail of the second slide rail assembly 24 respectively in order for the two slide rail assemblies 22 and 24 to support the chassis 34. (The second rail and the third rail of the second slide rail assembly 24 are not shown in the drawings due to limitations of the viewing angle.)

The cable management arm supporting device 20 includes a first arm 36, a first mounting member 38, a second arm 40, a second mounting member 42, a plurality of cable supporting features 44, a supporting base 46, a first supporting member 48, a second supporting member 50, and a third mounting member 52.

The first arm 36 has a first end 54a and a second end 54b. The first mounting member 38 is connected to the first arm 36 at a position adjacent to the first end 54a. For example, the first mounting member 38 is pivotally connected to the first arm 36 at a position adjacent to the first end 54a. In use, the first mounting member 38 is mounted to the first rail 28 of the first slide rail assembly 22. Preferably, the first slide rail assembly 22 includes a first connector 56 connected with the first rail 28 of the first slide rail assembly 22 (e.g., the first connector 56 being connected to the first rail 28 at a position adjacent to an end portion thereof), and the first mounting member 38 is mounted to the first connector 56. For example, the first mounting member 38 is releasably mounted to the first connector 56.

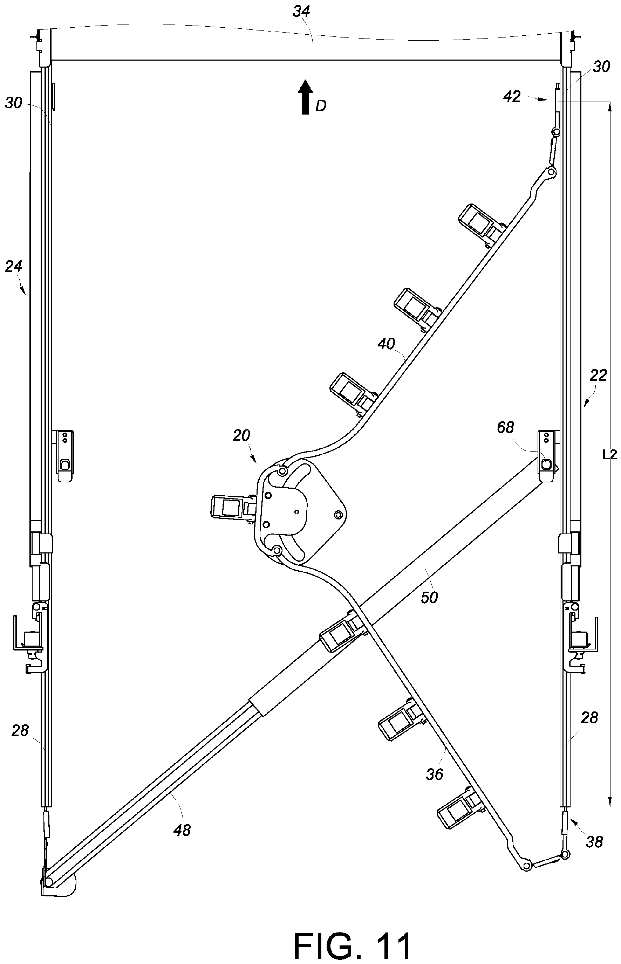

The second arm 40 is movably connected to the first arm 36 at a position adjacent to the second end 54b. In a preferred embodiment, the second arm 40 is pivotally connected with the first arm 36 via a hinge member 58 (or a hinge structure) in order to be extended (see FIG. 11) or retracted relative to the first arm 36.

The second mounting member 42 is connected with the second arm 40. For example, the second mounting member 42 is pivotally connected to the second arm 40 at a position adjacent to an end portion thereof. In use, the second mounting member 42 is mounted to the second rail 30 of the first slide rail assembly 22. Preferably, the first slide rail assembly 22 includes a second connector 60 connected with the second rail 30 of the first slide rail assembly 22 (e.g., the second connector 60 being connected to the second rail 30 at a position adjacent to an end portion thereof), and the second mounting member 42 is mounted to the second connector 60. For example, the second mounting member 42 is releasably mounted to the second connector 60.

The cable supporting features 44 are connected with one of the first arm 36 and the second arm 40. In a preferred embodiment, the cable supporting features 44 are connected with both the first arm 36 and the second arm 40. The cable supporting features 44 serve to hold the cables (not shown) of a server.

The supporting base 46 has a first supporting portion 62 and a second supporting portion 64 generally perpendicularly connected with the first supporting portion 62.

The first supporting member 48 is movably connected with the first supporting portion 62 of the supporting base 46. The second supporting member 50 is telescopically connected with the first supporting member 48. The first supporting member 48 and the second supporting member 50 are below one of the first arm 36 and the second arm 40 in order to serve supporting purposes, preventing the first arm 36 and the second arm 40 from falling because of the weight of the cables they carry.

As shown in FIG. 3 and FIG. 3A, the second supporting member 50 is mounted to the third rail 32 of the first slide rail assembly 22. In a preferred embodiment, the first slide rail assembly 22 further includes an auxiliary element 66 connected with the third rail 32 of the first slide rail assembly 22 (e.g., at a position adjacent to an end portion of the third rail 32) and also includes a positioning element 68 connected with the second supporting member 50.

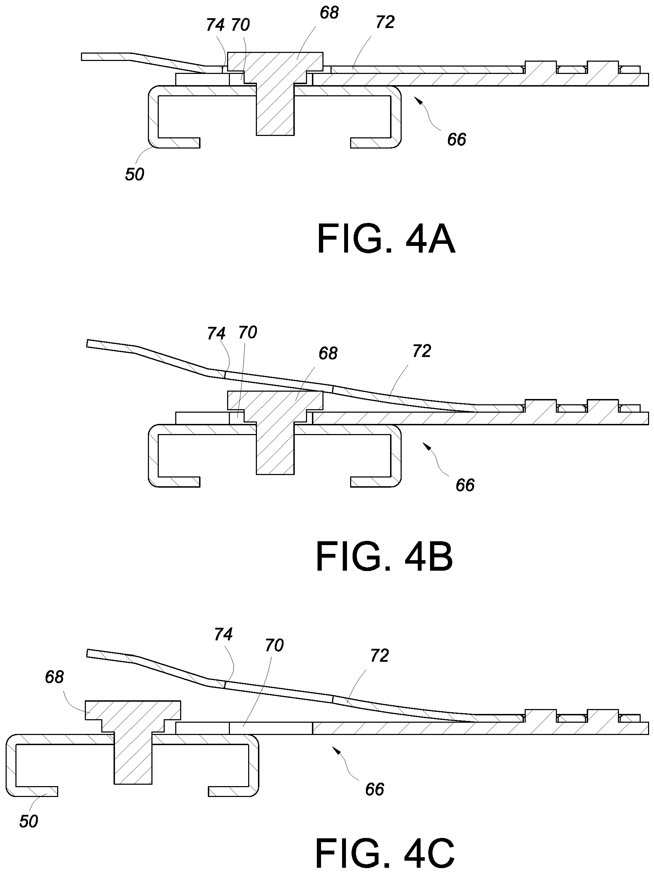

More specifically, referring to FIG. 3A and FIGS. 4A-4C, the auxiliary element 66 includes a mounting opening 70 and an elastic arm 72. The elastic arm 72 has one end fixed at an appropriate position and has a blocking edge 74 for forming a blockage at the mounting opening 70. The positioning element 68 can be mounted in the mounting opening 70 and be blocked by the blocking edge 74 of the elastic arm 72.

For example, once the positioning element 68 connected with the second supporting member 50 enters the mounting opening 70 of the auxiliary element 66, the blocking edge 74 of the elastic arm 72 can block the positioning element 68 such that the positioning element 68 is mounted in the mounting opening 70 of the auxiliary element 66 (see FIG. 4A). Preferably, either of the positioning element 68 and the elastic arm 72 has a guiding feature (e.g., an inclined surface), such that the elastic arm 72 of the auxiliary element 66 can be directly pushed up by the positioning element 68 upon connection between the second supporting member 50 and the auxiliary element 66 and then return to its original position to keep the positioning element 68 in place. In that case, manual operation of the elastic arm 72 will be unnecessary. On the other hand, when it is desired to release the positioning element 68 from the mounted state, the free end of the elastic arm 72 of the auxiliary element 66 can be lifted up to rid the mounting opening 70 of the blockage of the blocking edge 74 of the elastic arm 72 (see FIG. 4B). The positioning element 68 can now be removed from the mounting opening 70 of the auxiliary element 66 (see FIG. 4C), allowing the second supporting member 50 to be rapidly detached from the third rail 32 of the first slide rail assembly 22. According to the above, the second supporting member 50 is configured to be mounted to the third rail 32 of the first slide rail assembly 22 in a releasable manner.

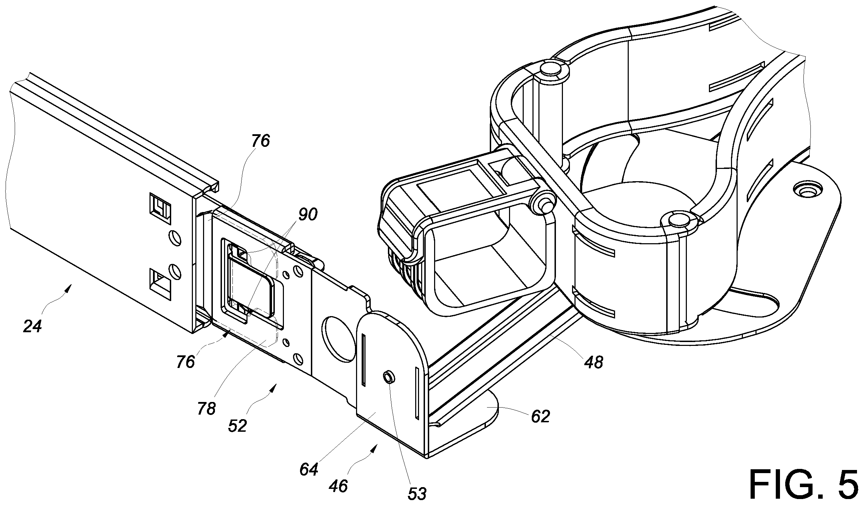

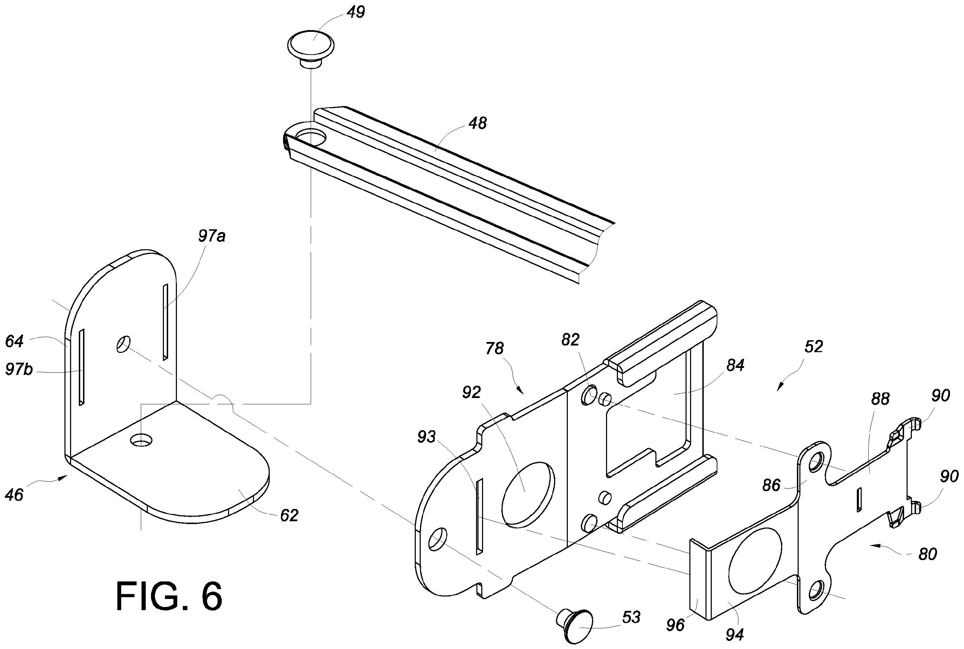

Referring to FIG. 5 and FIG. 6, the first supporting member 48 is pivotally connected with the first supporting portion 62 of the supporting base 46 via a pivotal connector 49 so as to pivot with respect to the first supporting portion 62 of the supporting base 46. The third mounting member 52 is pivotally connected with the second supporting portion 64 of the supporting base 46 via a pivotal connector 53 so as to pivot with respect to the second supporting portion 64 of the supporting base 46. In addition, the third mounting member 52 is connected with the second slide rail assembly 24 in a releasable manner, as detailed further below.

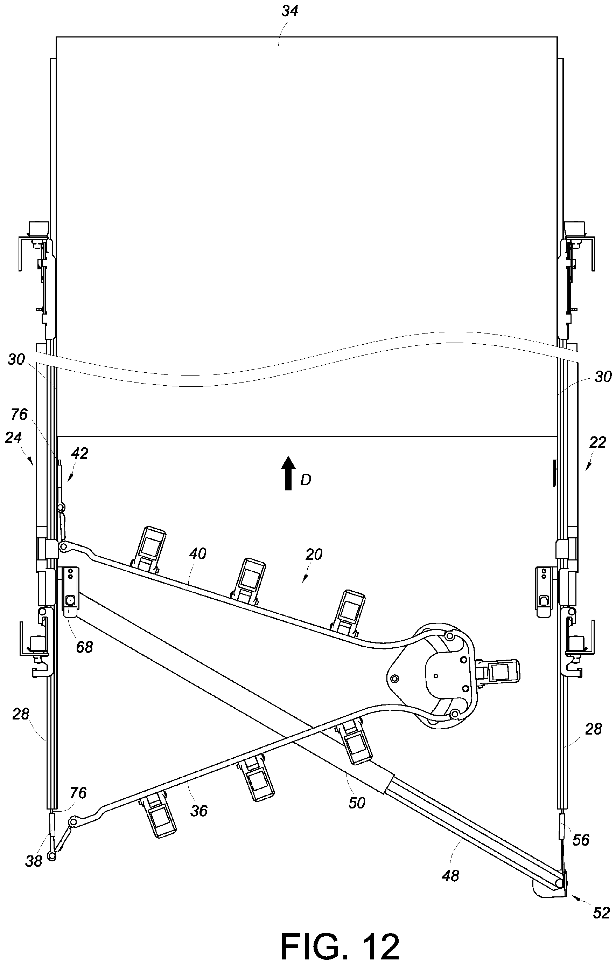

It is worth mentioning that the supporting base 46 and the third mounting member 52 can be viewed as a mounting assembly applicable to a supporting member (e.g., the first supporting member 48). The mounting assembly enables the supporting member to pivot to different directions via the third mounting member 52 so that the supporting member can be mounted to different objects. For instance, the supporting member can be mounted to the second slide rail assembly 24 via the third mounting member 52, or the supporting member can be mounted to the first slide rail assembly 22 via the third mounting member 52 (see FIG. 12).

In a preferred embodiment, the second slide rail assembly 24 further includes a connector 76 connected with the first rail 28 of the second slide rail assembly 24, and the third mounting member 52 further includes a mounting wall 78 and an operation arm 80 corresponding to and connected with the mounting wall 78. The mounting wall 78 includes at least one fixing portion 82 and a first opening 84. The operation arm 80 includes a connecting portion 86 corresponding to and fixedly connected with the at least one fixing portion 82. The operation arm 80 also includes a first elastic portion 88 connected with one side of the connecting portion 86 and corresponding to the first opening 84.

The first elastic portion 88 includes at least one engaging portion 90 for blocking an object. For example, when the third mounting member 52 is connected with the connector 76 of the second slide rail assembly 24, the at least one engaging portion 90 corresponds to and blocks a portion of the connector 76 to keep the third mounting member 52 and the connector 76 in a mounted state. An operator can operate (e.g., press) the first elastic portion 88 through the first opening 84 to displace the at least one engaging portion 90 with respect to the portion of the connector 76, thus releasing the third mounting member 52 and the connector 76 from the mounted state, allowing the third mounting member 52 to be detached from the connector 76.

Preferably, the mounting wall 78 of the third mounting member 52 further includes a second opening 92 and a through hole 93, and the operation arm 80 further includes a second elastic portion 94 connected with another side of the connecting portion 86 (for example, but without limitation, the second elastic portion 94 and the first elastic portion 88 are located on two opposite sides of the connecting portion 86 respectively and use the connecting portion 86 as a common fulcrum) and corresponding to the second opening 92. In addition, an engaging section 96 is connected with the second elastic portion 94. The engaging section 96 corresponds to and can pass through the through hole 93 of the mounting wall 78. On the other hand, the second supporting portion 64 of the supporting base 46 further includes a first positioning portion 97a and a second positioning portion 97b. The engaging section 96 can engage with the first positioning portion 97a or the second positioning portion 97b after passing through the through hole 93 of the mounting wall 78.

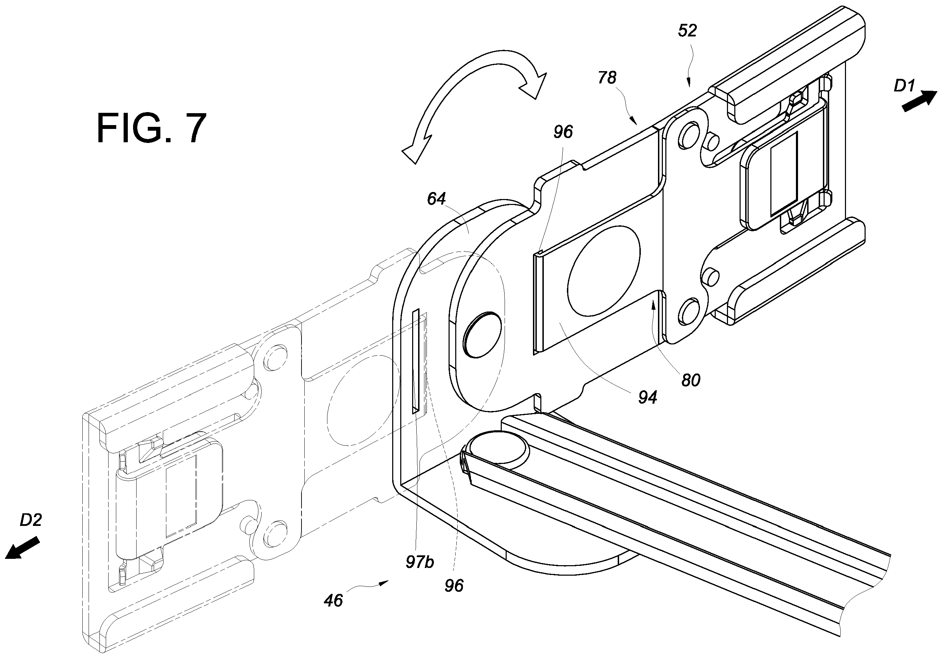

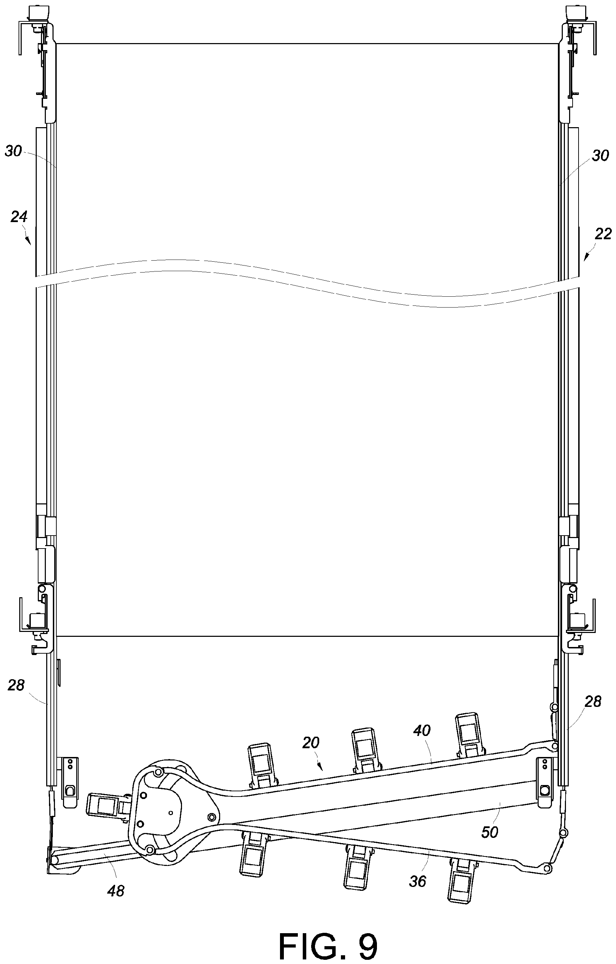

More specifically, referring to FIG. 7, the third mounting member 52, which is pivotally connected with the second supporting portion 64 of the supporting base 46, can be pivoted to a first direction D1 or a second direction D2. Preferably, the first direction D1 and the second direction D2 are opposite directions. The third mounting member 52, therefore, can be mounted to the connector 76 of the second slide rail assembly 24 when pivoted to the first direction D1 and can be mounted to a connector of the first slide rail assembly 22 when pivoted to the second direction D2 (as explained further below with reference to FIGS. 9-12).

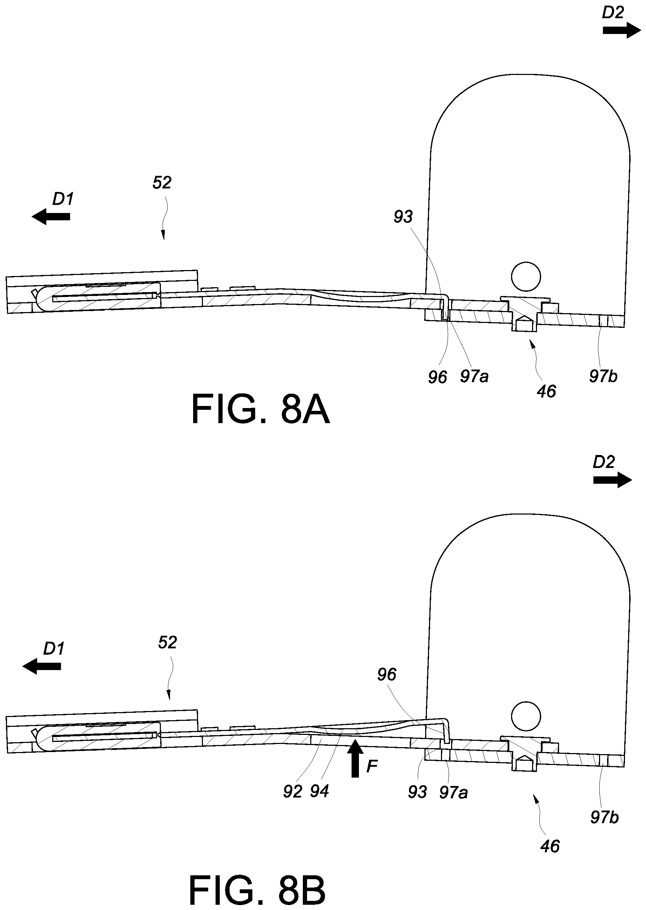

Referring to FIGS. 8A-8B in conjunction with FIG. 7, once the third mounting member 52 is pivoted to the first direction D1, the engaging section 96 sequentially passes through the through hole 93 of the mounting wall 78 and the first positioning portion 97a of the supporting base 46 and becomes engaged with the first positioning portion 97a to limit and fix the third mounting member 52 in position. Thus, the stability of the third mounting member 52 is increased, which is advantageous to the mounting process.

When it is desired to pivot the third mounting member 52 from the first direction D1 to the second direction D2, the operator can apply a force F to (i.e., press) the second elastic portion 94 of the operation arm 80 through the second opening 92 to disengage the engaging section 96 from the through hole 93 and the first positioning portion 97a of the supporting base 46. Then, the third mounting member 52 can be pivoted from the first direction D1 to the second direction D2, allowing the engaging section 96 to engage with the second positioning portion 97b of the supporting base 46 and thereby limit and fix the third mounting member 52 in position. Consequently, the stability of the third mounting member 52 is increased, which facilitates mounting. It can be known from the above that the engaging section 96 can selectively engage with either of the first positioning portion 97a and the second positioning portion 97b.

Referring to FIG. 9, when the second rail 30 of the first slide rail assembly 22 and the second rail 30 of the second slide rail assembly 24 are in a retracted position relative to their respective first rails 28, the second arm 40 is close to the first arm 36, and the second supporting member 50 is retracted relative to the first supporting member 48.

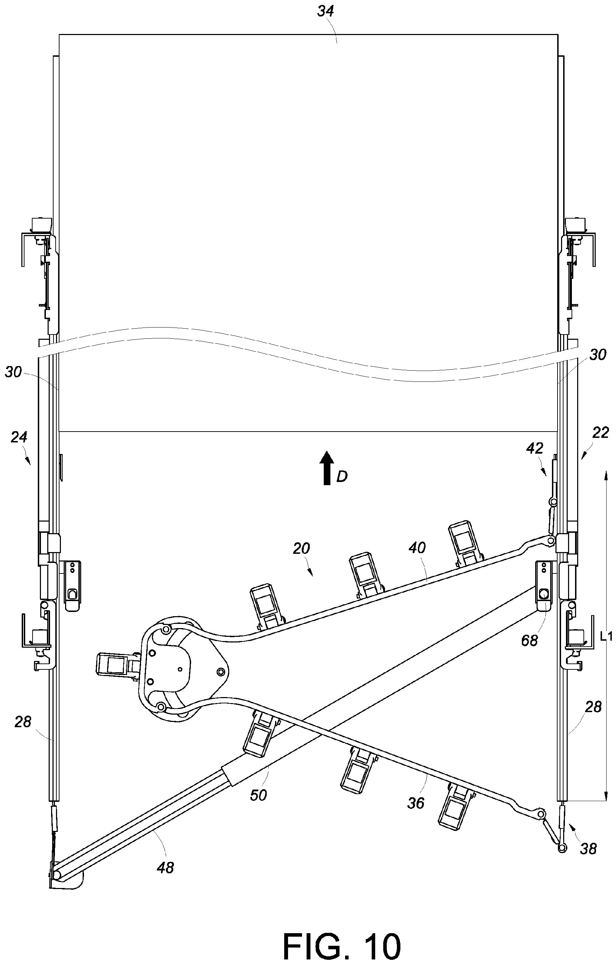

Referring to FIG. 10, when the second rail 30 of the first slide rail assembly 22 and the second rail 30 of the second slide rail assembly 24 are longitudinally displaced a distance L1 in a direction D from the retracted position toward an extended position relative to their respective first rails 28, the chassis 34 is also displaced in the direction D. Meanwhile, the second mounting member 42 of the cable management arm supporting device 20 is displaced relative to the first mounting member 38 in the direction D, and the second arm 40 is extended relative to the first arm 36. Since the third rail 32 (see FIG. 2) of the first slide rail assembly 22 is also driven to displace longitudinally in the direction D by the second rail 30 of the first slide rail assembly 22, the second supporting member 50, which is connected with the third rail 32 of the first slide rail assembly 22 via the positioning element 68, is displaced relative to the first supporting member 48 in response to extension of the second arm 40 relative to the first arm 36.

Referring to FIG. 11, when the second rail 30 of the first slide rail assembly 22 and the second rail 30 of the second slide rail assembly 24 are longitudinally displaced further in the direction D so as to be a distance L2 from the retracted position relative to their respective first rails 28, the chassis 34 is also displaced in the direction D. In the meantime, the second mounting member 42 of the cable management arm supporting device 20 is further displaced relative to the first mounting member 38 in the direction D, and the second arm 40 is further extended relative to the first arm 36. Since the third rail 32 of the first slide rail assembly 22 is also driven by the second rail 30 of the first slide rail assembly 22 to displace longitudinally further in the direction D, the second supporting member 50, which is connected with the third rail 32 of the first slide rail assembly 22 via the positioning element 68, is further displaced relative to the first supporting member 48 in response to further extension of the second arm 40 relative to the first arm 36.

It can be known from FIGS. 9-11 that the second arm 40 is extended (or folded) relative to the first arm 36 in response to displacement of the second rail 30 of the first slide rail assembly 22, and that the second supporting member 50 is displaced relative to the first supporting member 48 in response to displacement of the third rail 32 of the first slide rail assembly 22. Therefore, in the course in which the chassis 34 is pulled out or pushed back in place, the first arm 36 and the second arm 40 jointly provide cable management (e.g., to keep the cables behind the server chassis 34 in neat arrangement) while the first supporting member 48 and the second supporting member 50 cooperate in providing support (e.g., to support the first arm 36).

FIG. 12 shows how the cable management arm supporting device 20 in another embodiment of the present invention is applied to and works with the first slide rail assembly 22 and the second slide rail assembly 24.

When the third mounting member 52 is pivoted to the second direction D2 (see FIG. 7), it can be mounted in a different way from that illustrated in the foregoing embodiment (as shown in FIGS. 9-11), or more particularly be mounted to the first connector 56 on the first rail 28 of the first slide rail assembly 22. Meanwhile, the first mounting member 38 and the second mounting member 42, which are respectively pivotally connected with the first arm 36 and the second arm 40, can also be pivoted to the second direction D2 in order to be mounted to the connector 76 and another connector 76 of the second slide rail assembly 24 respectively. The connecters 76 are connected with the first rail 28 and the second rail 30 of the second slide rail assembly 24, respectively. In use, therefore, the arrangement of the cable management arm supporting device 20 with respect to the first slide rail assembly 22 and the second slide rail assembly 24 can be inverted to suit practical needs.

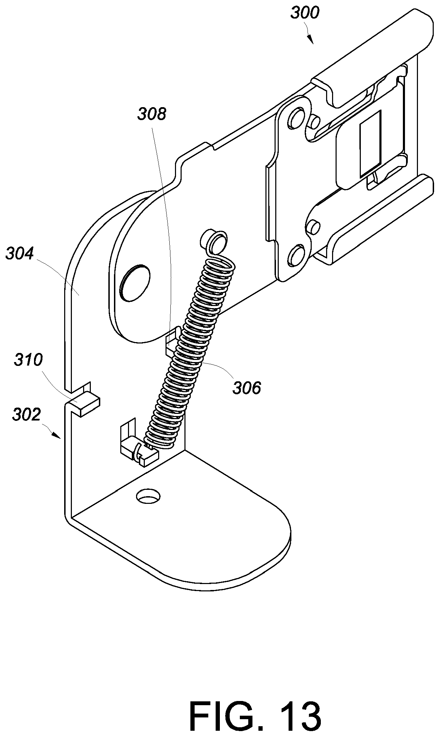

FIG. 13 shows how the third mounting member 300 of the cable management arm supporting device in the second embodiment of the present invention is arranged in relation to the supporting base 302. As in the previous embodiment, the third mounting member 300 is pivotally connected with the second supporting portion 304 of the supporting base 302. However, the second embodiment is different from the first embodiment (see FIG. 7) in that the cable management arm supporting device further includes an elastic element 306 connected between the third mounting member 300 and the second supporting portion 304 of the supporting base 302, and that the second supporting portion 304 of the supporting base 302 further includes a first stop portion 308 and a second stop portion 310.

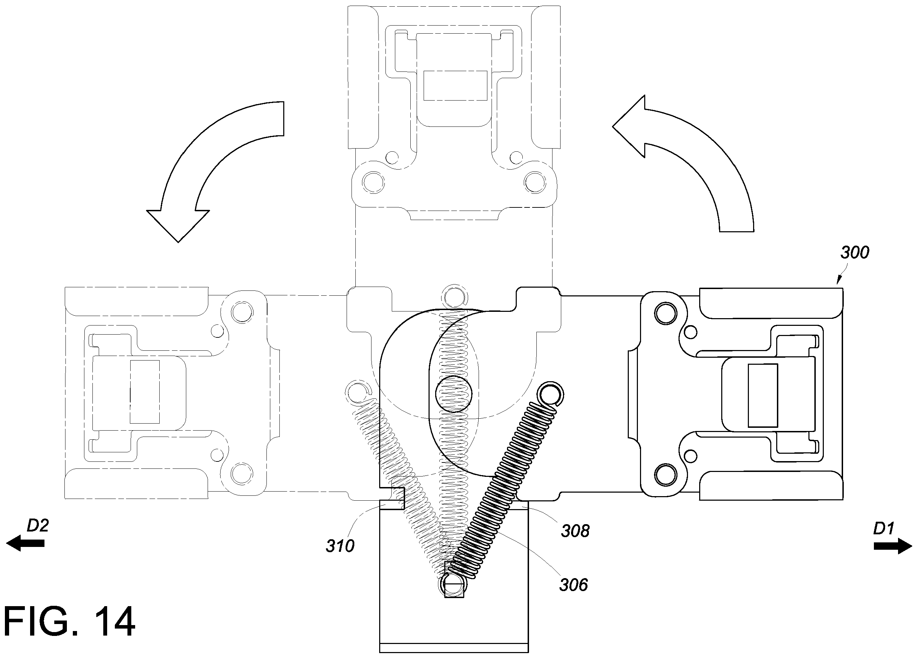

As shown in FIG. 14, when the third mounting member 300 is pivoted to a first direction D1, it is pressed against the first stop portion 308 due to the elastic element 306 and is thus limited in position. Once the third mounting member 300 is pivoted from the first direction D1 to a second direction D2 opposite the first direction D1, it is pressed against the second stop portion 310 due to the elastic element 306 and hence limited in position.

While the present invention has been disclosed through the foregoing preferred embodiments, it is understood that the embodiments are not intended to be restrictive of the present invention. The scope of patent protection sought is defined by the appended claims.

## Claims

1. A mounting assembly being movably connected to a first supporting member (48) of a cable management arm supporting device (20), the mounting assembly comprising:
a supporting base (46, 302) having a first supporting portion (62) and a second supporting portion (64, 304) perpendicularly connected with the first supporting portion (62), the first supporting member (48) being movably connected with the first supporting portion (62); and
a third mounting member (52, 300) pivotally connected with the second supporting portion (64, 304) of the supporting base (46, 302), to be pivoted to a first direction (D1) or a second direction (D2) which first and second directions (D1, D2) are opposite directions,
wherein the second supporting portion (64, 304) comprises a first positioning portion (97a) and a second positioning portion (97b) or a first stop portion (308) and a second stop portion (310),
wherein the third mounting member (52, 300) engages the first positioning portion (97a) or the first stop portion (308) when pivoted to the first direction (D1) and engages the second positioning portion (97b) or the second stop portion (310) when pivoted to the second direction (D2) and is thus limited in position, when pivoted to the first and second directions (D1, D2),
**characterized in,**
**that** the third mounting member (52, 300) comprises a second elastic portion (94) or an elastic element (306),
wherein the third mounting member (52) engages the first and second positioning portion (97a, 97b) with an engaging section (96) which is part of the second elastic portion (94) or wherein the third mounting member (300) is pressed against the first and the second stop portions (308) by the elastic element (306).

2. The mounting assembly as claimed in claim 1, wherein the second elastic portion (94) is part of an operation arm (80) of the third mounting member (52).

3. The mounting assembly as claimed in claim 1, wherein the elastic element (306) is connected between the third mounting member (300) and the second supporting portion (304) of the supporting base (302).

4. The mounting assembly as claimed in claim 1, wherein the third mounting member (52, 300) further includes a mounting wall (78) and an operation arm (80) connected with the mounting wall (78), the mounting wall (78) includes at least one fixing portion (82) and a first opening (84), the operation arm (80) includes a connecting portion (86) connected with the at least one fixing portion (82) and includes a first elastic portion (88) connected with one side of the connecting portion (86) and corresponding to the first opening (84), and the first elastic portion (88) includes at least one engaging portion (90) for blocking an object (76).

5. The mounting assembly as claimed in claim 4, wherein the mounting wall (78) of the third mounting member (52) includes a second opening (92), the operation arm (80) includes the second elastic portion (94) connected with an other side of the connecting portion (86) and corresponding to the second opening (92) and also includes the engaging section (96) connected with the second elastic portion (94), the second supporting portion (64) of the supporting base (46) includes the first positioning portion (97a) and the second positioning portion (97b), and the engaging section (96) is selectively engagable with one of the first positioning portion (97a) and the second positioning portion (97b).

6. The mounting assembly as claimed in claim 1, wherein the elastic element (306) is connected between the third mounting member (300) and the second supporting portion (304) of the supporting base (302), the second supporting portion (304) of the supporting base (302) further including the first stop portion (308) and the second stop portion (310), wherein the third mounting member (300) is pressed against the first stop portion (308) due to the elastic element (306) when pivoted to the first direction (D1) and is pressed against the second stop portion (310) due to the elastic element (306) when pivoted to the second direction (D2) opposite the first direction (D1).

7. A cable management arm supporting device (20), to be mounted to a first slide rail assembly (22) and a second slide rail assembly (24), wherein the first slide rail assembly (22) includes a first rail (28), a second rail (30), and a third rail (32) movably connected between the first rail (28) and the second rail (30), the cable management arm supporting device (20) comprising:
a first arm (36) having a first end (54a) and a second end (54b);
a first mounting member (38) connected to the first arm (36) at a position adjacent to the first end (54a), the first mounting member (38) being mounted to the first rail (28) of the first slide rail assembly (22);
a second arm (40) movably connected to the first arm (36) at a position adjacent to the second end (54b);
a second mounting member (42) connected with the second arm (40), the second mounting member (42) being mounted to the second rail (30) of the first slide rail assembly (22);
a plurality of cable supporting features (44) connected with at least one of the first arm (36) and the second arm (40); and
the mounting assembly according to claim 1, wherein the mounting assembly further includes a second supporting member (50), the second supporting member (50) is telescopically connected with the first supporting member (48) and mounted to the third rail (32) of the first slide rail assembly (22), and the third mounting member (52, 300) is releasably connected with the second slide rail assembly (24).

8. The cable management arm supporting device (20) as claimed in claim 7,
wherein the first slide rail assembly (22) further includes a first connector (56) connected with the first rail (28), and the first mounting member (38) is releasably mounted to the first connector (56).

9. The cable management arm supporting device (20) as claimed in claim 7,
wherein the first slide rail assembly (22) further includes a second connector (60) connected with the second rail (30), and the second mounting member (42) is releasably mounted to the second connector (60).

10. The cable management arm supporting device (20) as claimed in claim 7,
wherein the second slide rail assembly (24) further includes a connector (76), the third mounting member (52, 300) further includes a mounting wall (78) and an operation arm (80) connected with the mounting wall (78), the mounting wall (78) includes at least one fixing portion (82) and a first opening (84), the operation arm (80) includes a connecting portion (86) connected with the at least one fixing portion (82) and includes a first elastic portion (88) connected with one side of the connecting portion (86) and corresponding to the first opening (84), and the first elastic portion (88) includes at least one engaging portion (90) for blocking the connector (76).

11. The cable management arm supporting device (20) as claimed in claim 10,
wherein the mounting wall (78) of the third mounting member (52, 300) includes a second opening (92), the operation arm (80) includes the second elastic portion (94) connected with an other side of the connecting portion (86) and corresponding to the second opening (92) and also includes the engaging section (96) connected with the second elastic portion (94), the second supporting portion (64) of the supporting base (46) includes the first positioning portion (97a) and the second positioning portion (97b), and the engaging section (96) is selectively engagable with one of the first positioning portion (97a) and the second positioning portion (97b).

12. The cable management arm supporting device (20) as claimed in claim 7,
wherein the elastic element (306) is connected between the third mounting member (300) and the second supporting portion (304) of the supporting base (302), the second supporting portion (304) of the supporting base (302) further including the first stop portion (308) and the second stop portion (310), wherein the third mounting member (52, 300) is pressed against the first stop portion (308) due to the elastic element (306) when pivoted to the first direction (D1) and is pressed against the second stop portion (310) due to the elastic element (306) when pivoted to the second direction (D2) opposite the first direction (D1).

13. The cable management arm supporting device (20) as claimed in claim 7,
further including an auxiliary element (66) connected with the third rail (32) of the first slide rail assembly (22) and a positioning element (68) connected with the second supporting member (50), wherein the auxiliary element (66) includes a mounting opening (70) and an elastic arm (72), the elastic arm (72) has a blocking edge (74) for forming a blockage at the mounting opening (70), and the positioning element (68) is mounted in the mounting opening (70) and can be blocked by the blocking edge (74) of the elastic arm (72).

14. The cable management arm supporting device (20) as claimed in claim 7,
further including a hinge member (58) by which the first arm (36) and the second arm (40) are pivotally connected.

15. The cable management arm supporting device (20) as claimed in claim 7,
wherein the first mounting member (38) is pivotally connected with the first end (54a) of the first arm (36).

16. The cable management arm supporting device (20) as claimed in claim 7,
wherein the second mounting member (42) is pivotally connected with the second arm (40).

17. The cable management arm supporting device (20) as claimed in claim 7,
wherein the first supporting member (48) is pivotally connected with the first supporting portion (62) of the supporting base (46, 302).

## Patentansprüche

1. Eine Montagezusammensetzung, die beweglich an einem ersten Stützglied (48) einer Auflageeinrichtung (20) des Kabelführungsarms befestigt ist, wobei die Montagezusammensetzung die folgenden Komponenten umfasst:
eine tragende Basis (46, 302) mit einem ersten Stützteil (62) und einem zweiten Stützteil (64, 304), der senkrecht zum ersten Stützteil (62) befestigt ist; das erste Stützglied (48) beweglich am ersten Stützteil (62) befestigt ist; und
ein drittes Stützglied (52, 300), das drehgelenkig am zweiten Stützteil (64, 304) der tragenden Basis (46, 302) befestigt ist, um in eine erste Richtung (D1) oder in eine zweite Richtung (D2) gedreht zu werden, wobei die erste und die zweite Richtungen (D1, D2) entgegengesetzte Richtungen sind;
worin der zweite Stützteil (64, 304) einen ersten Positionierteil (97a) und einen zweiten Positionierteil (97b) oder einen ersten Anschlagteil (308) und einen zweiten Anschlagteil (310) umfasst;
worin das dritte Stützglied (52, 300) beim Drehen in die erste Richtung (D1) mit dem ersten Positionierteil (97a) oder mit dem ersten Anschlagteil (308) und beim Drehen in die zweite Richtung (D2) mit dem zweiten Positionierteil (97b) oder mit dem zweiten Anschlagteil (310) in Eingriff gebracht wird und daher dessen Position beim Drehen in die erste und zweite Richtung (D1, D2) begrenzt ist;
**dadurch gekennzeichnet,**
**dass** das dritte Stützglied (52, 300) einen zweiten elastischen Teil (94) oder eine Feder (306) umfasst,
worin das dritte Stützglied (52) mit dem ersten und zweiten Positionierteil (97a, 97b) mit einem Eingriffteil (96), der Teil des zweiten elastischen Teils (94) ist, in Eingriff gebracht wird, oder worin das dritte Stützglied (300) mit der Feder (306) an die ersten und zweiten Anschlagteile (308) gedrückt wird.

2. Die Montagezusammensetzung nach Anspruch 1, worin der zweite elastische Teil (94) Teil eines Betätigungsarms (80) des dritten Stützglieds (52) ist.

3. Die Montagezusammensetzung nach Anspruch 1, worin die Feder (306) zwischen dem dritten Stützglied (300) und dem zweiten Stützteil (304) der tragenden Basis (302) befestigt ist.

4. Die Montagezusammensetzung nach Anspruch 1, worin das dritte Stützglied (52, 300) weiter aus einer Montagewand (78) und einem Betätigungsarm (80), der an der Montagewand (78) befestigt ist, besteht; an der Montagewand (78) mindestens ein Befestigungsteil (82) vorgesehen ist und die Montagewand (78) eine erste Öffnung (84) aufweist; der Betätigungsarm (80) aus einem Verbindungsteil (86) besteht, der am mindestens einen Befestigungsteil (82) befestigt und mit einem ersten elastischen Teil (88), der auf einer Seite des Verbindungsteils (86) und in Übereinstimmung_mit der ersten Öffnung (84) befestigt ist, gebildet ist; der erste elastische Teil (88) aus mindestens einem Eingriffteil (90) zum Sperren eines Gegenstands (76) besteht.

5. Die Montagezusammensetzung nach Anspruch 4, worin die Montagewand (78) des dritten Stützglieds (52) eine zweite Öffnung (92) aufweist; der Betätigungsarm (80) aus einem zweiten elastischen Teil (94), der auf einer anderen Seite des Verbindungsteils (86) und in Übereinstimmung mit der zweiten Öffnung (92) befestigt und ebenfalls aus dem Eingriffteil (96) besteht, wobei dieser Eingriffteil (96) am zweiten elastischen Teil (94) befestigt ist; der zweite Stützteil (64) der tragenden Basis (46) aus dem ersten Positionierteil (97a) und dem zweiten Positionierteil (97b) besteht; der Eingriffteil (96) wahlweise mit einem der ersten Positionierteile (97a) und mit dem zweiten Positionierteil (97b) in Eingriff gebracht wird.

6. Die Montagezusammensetzung nach Anspruch 1, worin die Feder (306) zwischen dem dritten Stützglied (300) und dem zweiten Stützteil (304) der tragenden Basis (302) befestigt ist; der zweite Stützteil (304) der tragenden Basis (302) weiter aus einem ersten Anschlagteil (308) und aus einem zweiten Anschlagteil (310) besteht; worin das dritte Stützglied (300) beim Drehen in die erste Richtung (D1) mit der Feder (306) an den ersten Anschlagteil (308) und beim Drehen in die zweite Richtung (D2), d.h. in die entgegengesetzte Richtung der ersten Richtung (D1), mit der Feder (306) an den zweiten Anschlagteil (310) gedrückt wird.

7. Eine Auflageeinrichtung (20) des Kabelführungsarms, die an eine erste Laufschienenmontage (22) und an eine zweite Laufschienenmontage (24) montiert ist; worin die erste Laufschienenmontage (22) aus einer ersten Schiene (28), einer zweiten Schiene (30) und aus einer dritten Schiene (32), die beweglich zwischen der ersten Schiene (28) und der zweiten Schiene (30) befestigt ist, besteht; die Auflageeinrichtung (20) des Kabelführungsarms die folgenden Komponenten umfasst:
einen ersten Arm (36) mit einem ersten Endabschnitt (54a) und einem zweiten Endabschnitt (54b);
einem ersten Montageglied (38), das am ersten Arm (36) in einer Position angrenzend zum ersten Endabschnitt (54a) befestigt ist; das erste Montageglied (38) an der ersten Schiene (28) der ersten Laufschienenmontage (22) montiert ist;
einen zweiten Arm (40), der beweglich am ersten Arm (36) in einer Position angrenzend zum zweiten Endabschnitt (54b) befestigt ist;
einem zweiten Montageglied (42), das am zweiten zweiter Arm (40) befestigt ist; das zweite Montageglied (42) an der zweiten Schiene (30) der ersten Laufschienenmontage (22) montiert ist;
mehreren Kabeltragevorrichtungen (44), die am mindestens einen der ersten Arme (36) und der zweiten Arme (40) befestigt sind; und
die Montagezusammensetzung nach Anspruch 1, worin die Montagezusammensetzung weiter aus einem zweiten Stützglied (50) besteht; das zweite Stützglied (50) teleskopisch am ersten Stützglied (48) befestigt und an der dritten Schiene (32) der ersten Laufschienenmontage (22) befestigt ist; das dritte Stützglied (52, 300) entfernbar an der zweiten Laufschienenmontage (24) befestigt ist.

8. Die Auflageeinrichtung (20) des Kabelführungsarms nach Anspruch 7, worin die erste Laufschienenmontage (22) weiter aus einem ersten Steckverbinder (56) besteht, der an der ersten Schiene (28) befestigt ist; das erste Montageglied (38) entfernbar am ersten Steckverbinder (56) montiert ist.

9. Die Auflageeinrichtung (20) des Kabelführungsarms nach Anspruch 7, worin die erste Laufschienenmontage (22) weiter aus einem zweiten Steckverbinder (60) besteht, der an der zweiten Schiene (30) befestigt ist; das zweite Montageglied (42) entfernbar am zweiten Steckverbinder (60) montiert ist.

10. Die Auflageeinrichtung (20) des Kabelführungsarms nach Anspruch 7, worin die zweite Laufschienenmontage (24) weiter aus einem Steckverbinder (76) besteht; das dritte Stützglied (52, 300) weiter aus einer Montagewand (78) und einem Betätigungsarm (80), der an der Montagewand (78) befestigt ist, besteht; die Montagewand (78) aus mindestens einem Befestigungsteil (82) besteht und eine erste Öffnung (84) aufweist; der Betätigungsarm (80) aus einem Verbindungsteil (86), das an dem mindestens einen Befestigungsteil (82) befestigt ist, besteht, und aus einem ersten elastischen Teil (88), der auf einer Seite des Verbindungsteils (86) und in Übereinstimmung mit der ersten Öffnung (84) befestigt ist, besteht; der erste elastische Teil (88) aus mindestens einem Eingriffteil (90) zum Sperren des Steckverbinders (76) besteht.

11. Die Auflageeinrichtung (20) des Kabelführungsarms nach Anspruch 10, worin die Montagewand (78) des dritten Stützglieds (52, 300) eine zweite Öffnung (92) aufweist; der Betätigungsarm (80) aus dem zweiten elastischen Teil (94), der auf einer anderen Seite des Verbindungsteils (86) und in Übereinstimmung mit der zweiten Öffnung (92) befestigt ist und ebenfalls aus dem Eingriffteil (96) besteht, wobei der Eingriffteil (96) am zweiten elastischen Teil (94) befestigt ist; der zweite Stützteil (64) der tragenden Basis (46) aus dem ersten Positionierteil (97a) und dem zweiten Positionierteil (97b) besteht; der Eingriffteil (96) wahlweise mit einem der ersten Positionierteile (97a) und mit dem zweiten Positionierteil (97b) in Eingriff gebracht wird.

12. Die Auflageeinrichtung (20) des Kabelführungsarms nach Anspruch 7, worin die Feder (306) zwischen dem dritten Stützglied (300) und dem zweiten Stützteil (304) der tragenden Basis (302) befestigt ist; der zweite Stützteil (304) der tragenden Basis (302) weiter aus dem ersten Anschlagteil (308) und dem zweiten Anschlagteil (310) besteht; worin das dritte Stützglied (52, 300) beim Drehen in die erste Richtung (D1) mit der Feder (306) an den ersten Anschlagteil (308) und beim Drehen in die zweite Richtung (D2), d.h. in die entgegengesetzte Richtung der ersten Richtung (D1), mit der Feder (306) an den zweiten Anschlagteil (310) gedrückt wird.

13. Die Auflageeinrichtung (20) des Kabelführungsarms nach Anspruch 7, weiter umfassend ein Nebenelement (66), das an der dritten Schiene (32) der ersten Laufschienenmontage (22) befestigt ist, während ein Positionierelement (68) am zweiten Stützglied (50) befestigt ist; worin das Nebenelement (66) eine Montageöffnung (70) aufweist und aus einem elastischen Arm (72) besteht; der elastische Arm (72) eine Sperrkante (74) zum Bilden einer Sperrung an der Montageöffnung (70) aufweist; das Positionierelement (68) in der Montageöffnung (70) montiert ist und mit der Sperrkante (74) des elastischen Arms (72) gesperrt werden kann.

14. Die Auflageeinrichtung (20) des Kabelführungsarms nach Anspruch 7, weiter umfassend ein Scharnier (58), mit dem der erste Arm (36) drehgelenkig am zweiten Arm (40) befestigt ist.

15. Die Auflageeinrichtung (20) des Kabelführungsarms nach Anspruch 7, worin das erste Montageglied (38) drehgelenkig am ersten Endabschnitt (54a) des ersten Arms (36) befestigt ist.

16. Die Auflageeinrichtung (20) des Kabelführungsarms nach Anspruch 7, worin das zweite Montageglied (42) drehgelenkig am zweiten Arm (40) befestigt ist.

17. Die Auflageeinrichtung (20) des Kabelführungsarms nach Anspruch 7, worin das erste Stützglied (48) drehgelenkig am ersten Stützteil (62) der tragenden Basis (46, 302) befestigt ist.

## Revendications

1. Ensemble de montage raccordé de manière mobile à un premier élément de support (48) d'un dispositif de support de bras de gestion de câbles (20), l'ensemble de montage **caractérisé par le fait qu'**il comprend :
une base de support (46, 302) présentant une première partie de support (62) et une seconde partie de support (64, 304) raccordée perpendiculairement à la première partie de support (62), le premier élément de support (48) étant raccordé de manière mobile à la première partie de support (62) ; et
un troisième élément de montage (52, 300) raccordé de manière pivotante à la seconde partie de support (64, 304) de la base de support (46, 302), pour pivoter dans une première direction (D1) ou une seconde direction (D2) les première et seconde directions (D1, D2) étant des directions opposées,
la seconde partie de support (64, 304) comprend une première partie de positionnement (97a) et une seconde partie de positionnement (97b) ou une première partie d'arrêt (308) et une seconde partie d'arrêt (310),
le troisième élément de montage (52, 300) vient en prise avec la première partie de positionnement (97a) ou la première partie d'arrêt (308) lorsque pivoté dans la première direction (D1) et vient en prise avec la seconde partie de positionnement (97b) ou la seconde partie d'arrêt (310) lorsque pivoté dans la seconde direction (D2) et est par conséquent limité en position, lorsque pivoté vers les première et seconde directions (D1, D2),
**caractérisé en ce que**,
le troisième élément de montage (52, 300) comprend une seconde partie élastique (94) ou un élément élastique (306),
le troisième élément de montage (52) vient en prise avec les première et seconde parties de positionnement (97a, 97b) avec une section de mise en prise (96) qui fait partie de la seconde partie élastique (94) ou le troisième élément de montage (300) est pressé contre les première et seconde partie d'arrêts (308) par l'élément élastique (306).

2. Ensemble de montage selon la revendication 1, **caractérisé par le fait que** la seconde partie élastique (94) fait partie d'un bras de commande (80) du troisième élément de montage (52).

3. Ensemble de montage selon la revendication 1, **caractérisé par le fait que** l'élément élastique (306) est raccordé entre le troisième élément de montage (300) et la seconde partie de support (304) de la base de support (302).

4. Ensemble de montage selon la revendication 1, **caractérisé par le fait que** le troisième élément de montage (52, 300) comprend en outre une paroi de montage (78) et un bras de commande (80) raccordé à la paroi de montage (78), la paroi de montage (78) comprend au moins une partie de fixation (82) et une première ouverture (84), le bras de commande (80) comprend une partie de raccordement (86) raccordée à la ou aux parties de fixation (82) et comprend une première partie élastique (88) raccordée à un côté de la partie de raccordement (86) et correspondant à la première ouverture (84), et la première partie élastique (88) comprend au moins une partie de mise en prise (90) pour bloquer un objet (76).

5. Ensemble de montage selon la revendication 4, **caractérisé par le fait que** la paroi de montage (78) du troisième élément de montage (52) comprend une seconde ouverture (92), le bras de commande (80) comprend la seconde partie élastique (94) raccordée à un autre côté de la partie de raccordement (86) et correspondant à la seconde ouverture (92) et comprend également la section de mise en prise (96) raccordée à la seconde partie élastique (94), la seconde partie de support (64) de la base de support (46) comprend la première partie de positionnement (97a) et la seconde partie de positionnement (97b), et la section de mise en prise (96) peut être mise en prise de manière sélective avec soit la première partie de positionnement (97a) soit la seconde partie de positionnement (97b).

6. Ensemble de montage selon la revendication 1, **caractérisé par le fait que** l'élément élastique (306) est raccordé entre le troisième élément de montage (300) et la seconde partie de support (304) de la base de support (302), la seconde partie de support (304) de la base de support (302) comprenant en outre la première partie d'arrêt (308) et la seconde partie d'arrêt (310), le troisième élément de montage (300) est pressé contre la première partie d'arrêt (308) du fait de l'élément élastique (306) lorsque pivoté dans la première direction (D1) et est pressé contre la seconde partie d'arrêt (310) du fait de l'élément élastique (306) lorsque pivoté dans la seconde direction (D2) à l'opposé de la première direction (D1).

7. Dispositif de support de bras de gestion de câbles (20), à monter sur un premier ensemble de rails coulissant (22) et un second ensemble de rails coulissant (24), **caractérisé par le fait que** le premier ensemble de rails coulissant (22) comprend un premier rail (28), un deuxième rail (30), et un troisième rail (32) raccordé de manière mobile entre le premier rail (28) et le deuxième rail (30), le dispositif de support de bras de gestion de câbles (20) **caractérisé par le fait qu'**il comprend :
un premier bras (36) présentant une première extrémité (54a) et une seconde extrémité (54b) ;
un premier élément de montage (38) raccordé au premier bras (36) sur une position adjacente à la première extrémité (54a), le premier élément de montage (38) étant monté sur le premier rail (28) du premier ensemble de rails coulissant (22) ;
un second bras (40) raccordé de manière mobile au premier bras (36) sur une position adjacente à la seconde extrémité (54b) ;
un deuxième élément de montage (42) raccordé au second bras (40), le deuxième élément de montage (42) étant monté sur le deuxième rail (30) du premier ensemble de rails coulissant (22) ;
une pluralité de fonctionnalités de support (44) raccordées à au moins l'un des premier bras (36) ou second bras (40) ; et
l'ensemble de montage selon la revendication 1, **caractérisé par le fait que** l'ensemble de montage comprend en outre un second élément de support (50), le second élément de support (50) est raccordé de manière télescopique au premier élément de support (48) et monté sur le troisième rail (32) du premier ensemble de rails coulissant (22), et le troisième élément de montage (52, 300) est raccordé de manière amovible au second ensemble de rails coulissant (24).

8. Dispositif de support de bras de gestion de câbles (20) selon la revendication 7, **caractérisé par le fait que** le premier ensemble de rails coulissant (22) comprend en outre un premier connecteur (56) raccordé au premier rail (28), et le premier élément de montage (38) est monté de manière amovible sur le premier connecteur (56).

9. Dispositif de support de bras de gestion de câbles (20) selon la revendication 7, **caractérisé par le fait que** le premier ensemble de rails coulissant (22) comprend en outre un second connecteur (60) raccordé au deuxième rail (30), et le deuxième élément de montage (42) est monté de manière amovible sur le second connecteur (60).

10. Dispositif de support de bras de gestion de câbles (20) selon la revendication 7, **caractérisé par le fait que** le second ensemble de rails coulissant (24) comprend en outre un connecteur (76), le troisième élément de montage (52, 300) comprend en outre une paroi de montage (78) et un bras de commande (80) raccordé à la paroi de montage (78), la paroi de montage (78) comprend au moins une partie de fixation (82) et une première ouverture (84), le bras de commande (80) comprend une partie de raccordement (86) raccordée à la ou aux parties de fixation (82) et comprend une première partie élastique (88) raccordée à un côté de la partie de raccordement (86) et correspondant à la première ouverture (84), et la première partie élastique (88) comprend au moins une partie de mise en prise (90) pour bloquer le connecteur (76).

11. Dispositif de support de bras de gestion de câbles (20) selon la revendication 10, **caractérisé par le fait que** la paroi de montage (78) du troisième élément de montage (52, 300) comprend une seconde ouverture (92), le bras de commande (80) comprend la seconde partie élastique (94) raccordée à un autre côté de la partie de raccordement (86) et correspondant à la seconde ouverture (92) et comprend également la section de mise en prise (96) raccordée à la seconde partie élastique (94), la seconde partie de support (64) de la base de support (46) comprend la première partie de positionnement (97a) et la seconde partie de positionnement (97b), et la section de mise en prise (96) peut être mise en prise de manière sélective avec soit la première partie de positionnement (97a) soit la seconde partie de positionnement (97b).

12. Dispositif de support de bras de gestion de câbles (20) selon la revendication 7, **caractérisé par le fait que** l'élément élastique (306) est raccordé entre le troisième élément de montage (300) et la seconde partie de support (304) de la base de support (302), la seconde partie de support (304) de la base de support (302) comprenant en outre la première partie d'arrêt (308) et la seconde partie d'arrêt (310), le troisième élément de montage (52, 300) est pressé contre la première partie d'arrêt (308) du fait de l'élément élastique (306) lorsque pivoté dans la première direction (D1) et est pressé contre la seconde partie d'arrêt (310) du fait de l'élément élastique (306) lorsque pivoté dans la seconde direction (D2) à l'opposé de la première direction (D1).

13. Dispositif de support de bras de gestion de câbles (20) selon la revendication 7, **caractérisé par le fait qu'**il comprend en outre un élément auxiliaire (66) raccordé au troisième rail (32) du premier ensemble de rails coulissant (22) et un élément de positionnement (68) raccordé au second élément de support (50), l'élément auxiliaire (66) comprend une ouverture de montage (70) et un bras élastique (72), le bras élastique (72) présente un rebord de blocage (74) pour former un blocage à l'ouverture de montage (70), et l'élément de positionnement (68) est monté dans l'ouverture de montage (70) et peut être bloqué par le rebord de blocage (74) du bras élastique (72).

14. Dispositif de support de bras de gestion de câbles (20) selon la revendication 7, **caractérisé par le fait qu'**il comprend en outre un élément d'articulation (58) par lequel le premier bras (36) et le second bras (40) sont raccordés de manière pivotante.

15. Dispositif de support de bras de gestion de câbles (20) selon la revendication 7, **caractérisé par le fait que** le premier élément de montage (38) est raccordé de manière pivotante avec la première extrémité (54a) du premier bras (36).

16. Dispositif de support de bras de gestion de câbles (20) selon la revendication 7, **caractérisé par le fait que** le deuxième élément de montage (42) est raccordé de manière pivotante avec le second bras (40).

17. Dispositif de support de bras de gestion de câbles (20) selon la revendication 7, **caractérisé par le fait que** le premier élément de support (48) est raccordé de manière pivotante avec la première partie de support (62) de la base de support (46, 302).
